(19) Europäisches Patentamt
European Patent Office
Office européen des brevets

(11) **EP 2 041 625 B1**

(12) # EUROPÄISCHE PATENTSCHRIFT

(45) Veröffentlichungstag und Bekanntmachung des Hinweises auf die Patenterteilung:
**27.06.2012 Patentblatt 2012/26**

(21) Anmeldenummer: **07765066.1**

(22) Anmeldetag: **05.07.2007**

(51) Int Cl.:
*G03F 7/20* *(2006.01)*     *G02B 27/28* *(2006.01)*
*G02B 27/42* *(2006.01)*

(86) Internationale Anmeldenummer:
**PCT/EP2007/005943**

(87) Internationale Veröffentlichungsnummer:
**WO 2008/009353 (24.01.2008 Gazette 2008/04)**

(54) **BELEUCHTUNGSSYSTEM EINER MIKROLITHOGRAPHISCHEN PROJEKTIONSBELICHTUNGSANLAGE**

ILLUMINATION SYSTEM OF A MICROLITHOGRAPHIC PROJECTION EXPOSURE APPARATUS

SYSTEME D'ECLAIRAGE D'UN EQUIPEMENT D'ECLAIRAGE PAR PROJECTION MICROLITHOGAFIQUE

(84) Benannte Vertragsstaaten:
**DE FR NL**

(30) Priorität: **15.07.2006 DE 102006032878**

(43) Veröffentlichungstag der Anmeldung:
**01.04.2009 Patentblatt 2009/14**

(73) Patentinhaber: **Carl Zeiss SMT GmbH**
**73447 Oberkochen (DE)**

(72) Erfinder: **FIOLKA, Damian**
**73447 Oberkochen (DE)**

(74) Vertreter: **Schwanhäusser, Gernot et al**
**Ostertag & Partner**
**Patentanwälte**
**Epplestr. 14**
**70597 Stuttgart (DE)**

(56) Entgegenhaltungen:
**EP-A- 1 610 181      WO-A-2005/050325**
**DE-A1- 19 829 612      US-A1- 2005 146 704**
**US-A1- 2006 055 834**

**Beschreibung**

HINTERGRUND DER ERFINDUNG

1. Gebiet der Erfindung

Die Erfindung betrifft ein Beleuchtungssystem einer mikrolithographischen Projektionsbelichtungsanlage. Die Erfindung betrifft insbesondere ein Beleuchtungssystem, mit dem sich ein vom Beleuchtungswinkel abhängender Polarisationszustand des auf eine Maske auftreffenden Projektionslichts einstellen läßt.

2. Beschreibung des Standes der Technik

Integrierte elektrische Schaltkreise und andere mikrostrukturierte Bauelemente werden üblicherweise hergestellt, indem auf ein geeignetes Substrat, bei dem es sich beispielsweise um einen Silizium-Wafer handeln kann, mehrere strukturierte Schichten aufgebracht werden. Zur Strukturierung der Schichten werden diese zunächst mit einem Photolack bedeckt, der für Licht eines bestimmten Wellenlängenbereiches, z.B. Licht im tiefen ultravioletten Spektralbereich (DUV, *deep ultraviolet*), empfindlich ist. Anschließend wird der so beschichtete Wafer in einer Projektionsbelichtungsanlage belichtet. Dabei wird ein Muster aus beugenden Strukturen, das auf einer Maske angeordnet ist, auf den Photolack mit Hilfe eines Projektionsobjektivs abgebildet. Da der Abbildungsmaßstab dabei im allgemeinen kleiner als 1 ist, werden derartige Projektionsobjektive häufig auch als Reduktionsobjektive bezeichnet.

Nach dem Entwickeln des Photolacks wird der Wafer einem Ätzprozeß unterzogen, wodurch die Schicht entsprechend dem Muster auf der Maske strukturiert wird. Der noch verbliebene Photolack wird dann von den verbleibenden Teilen der Schicht entfernt. Dieser Prozeß wird so oft wiederholt, bis alle Schichten auf den Wafer aufgebracht sind.

Die bei der Belichtung verwendeten Projektionsbelichtungsanlagen enthalten ein Beleuchtungssystem, das mit einem Projektionslichtbündel die zu projizierenden Strukturen auf der Maske ausleuchtet. Das Beleuchtungssystem enthält als Lichtquelle im allgemeinen einen Laser, der linear polarisiertes Licht erzeugt. Insbesondere bei der Verwendung sehr kurzwelligen Projektionslichts (z.B. $\lambda$ = 157 nm) können jedoch bei bestimmten optischen Elementen unerwünschte polarisationsabhängige Effekte auftreten, welche die Abbildungseigenschaften des Projektionsobjektivs stören. Ein Beispiel hierfür ist die intrinsische Doppelbrechung von Kalziumfluorid ($CaF_2$), das bei diesen kurzen Wellenlängen eine deutlich höhere Transparenz als übliche Linsenmaterialien wie etwa Quarzglas aufweist und deswegen diese Materialien teilweise oder sogar ganz ersetzt.

Um derartige Polarisationsabhängigkeiten zu verringern, sind bei einigen derartiger Projektionsbelichtungsanlagen zusätzliche Maßnahmen vorgesehen, um das vom Laser erzeugte linear polarisierte Projektionslicht in zirkular polarisiertes Licht oder sogar in unpolarisiertes Licht umzuwandeln, wie dies etwa in der US 6 535 273 beschrieben ist.

Andererseits hat sich herausgestellt, daß sich in bestimmten Fällen der Kontrast der Abbildung erhöhen läßt, wenn wenigstens ein Teil des auf die Maske auftreffenden Projektionslichts eine Polarisationsvorzugsrichtung hat, also linear oder elliptisch polarisiert ist. Eine weitere Verbesserung des Kontrasts läßt sich häufig erzielen, wenn der Polarisationszustand von dem Beleuchtungswinkel abhängt, unter dem das Projektionslichtstrahlen auf die Maske treffen.

Die US 2004/0057036 A1 schlägt in diesem Zusammenhang vor, unter größeren Beleuchtungswinkeln nur s-polarisiertes Licht auf die Maske auftreffen zu lassen, da dieses in der Bildebene des Projektionsobjektivs ohne Kontrastverlust interferieren kann. Unter kleineren Beleuchtungswinkeln auf die Maske auftreffendes Licht kann hingegen unpolarisiert bleiben.

Aus der internationalen Anmeldung WO 2005/017620 ist ein Polarisator für ein Beleuchtungssystem bekannt, der vorzugsweise in einer Pupillenebene eines Maskierungsobjektivs angeordnet ist. Das Maskierungsobjektiv bildet eine Feldblende auf die Maske ab und legt damit die Geometrie des ausgeleuchteten Lichtfeldes fest. Der in dem Maskierungsobjektiv angeordnete Polarisator enthält geneigt zur optischen Achse angeordnete polarisationsselektive Strahlteilerschichten, die zwischen prismenförmigen Trägerelementen oder auf dünnen Trägerplatten aufgebracht sein können. Bei einem dort beschriebenen Ausführungsbeispiel ist der Polarisator so auslegt, daß in unterschiedlichen Bereichen der Pupillenebene unterschiedliche (lineare) Polarisationszustände erzeugt werden. Auf diese Weise läßt sich z.B. eine Quadrupolbeleuchtung einstellen, bei der das Licht im wesentlichen tangential polarisiert aus den Polen austritt. Somit ermöglicht es dieses bekannte Beleuchtungssystem, vom Beleuchtungswinkel abhängende Polarisationszustände des auf die Maske auftreffenden Projektionslichts einzustellen. Nachteilig bei diesem bekannten Polarisator ist allerdings, daß er relativ hohe Lichtverluste verursacht.

Aus der EP 1 367 446 A1 ist ein Beleuchtungssystem für eine Projektionsbelichtungsanlage bekannt, das ein diffraktives optisches Element enthält. Das diffraktive optische Element ist aus einer Vielzahl von Einzelelementen zusammengesetzt, die jeweils unterschiedliche Beugungseigenschaften haben können. Je nach Wahl der zusammengesetzten Einzelelemente kann auf diese Weise die Ausleuchtung in einer nachfolgenden Pupillenebene beeinflußt werden, ohne daß hierzu Linsen oder Axicon-Elemente entlang der optischen Achse verfahren werden müssen. Ferner erlaubt der modulare baukastenartige Aufbau des diffraktiven optischen Elements auch die Erzeugung relativ komplizierter Intensitätsverteilungen in der Pupillenebene, wie sie für die Abbildung bestimmter Strukturen in der Maske günstig sein können. Den Einzelelementen, aus denen das diffraktive optische Element aufgebaut ist, können auch polarisationsbeeinflussende Komponenten, zum Beispiel Polarisatoren oder Verzögerungsplättchen, zugeordnet sein. Dadurch lassen sich an unterschiedlichen Orten in der Pupillenebene unterschiedliche Polarisationszustände realisieren. Somit ist dieses bekannte Beleuchtungssystem ebenfalls grundsätzlich dazu geeignet, vom Beleuchtungswinkel abhängende Polarisationszustände des auf die Maske auftreffenden Projektionslichts einzustellen.

Da das diffraktive optische Element aus einer großen Zahl von Einzelelementen zusammengesetzt ist, entstehen relativ viele Randbereiche, die zur Entstehung von unerwünschtem Streulicht führen. Ferner müssen bei den polarisationsbeeinflussenden Komponenten relativ enge Dickentoleranzen eingehalten werden, was technologisch schwierig ist und deswegen zu hohen Kosten für das diffraktive optische Element führt.

Aus der EP 1 610 181 A2 ist ein Beleuchtungssystem einer mikrolithographischen Projektionsbelichtungsanlage bekannt, bei dem eine Anordnung von Viertelwellenlängen-Plättchen dazu verwendet wird, auf einer entsprechenden Anordnung von diffraktiven optischen Elementen unterschiedliche Polarisationszustände zu erzeugen. Die diffraktiven optischen Elemente richten das auftreffende Licht auf unterschiedliche Bereiche einer Pupillenebene. Die Auswahl dieser Bereiche in der Pupillenebene kann verändert werden, indem mit Hilfe von Mikrolinsen-Arrays, die mit Hilfe eines Revolverkopfs in den Strahlengang eingeführt werden können, unterschiedliche diffraktive optische Elemente ausgeleuchtet werden.

Aus der US 2006/0055834 A1 ist ein Beleuchtungssystem einer mikrolithographischen Projektionsbelichtungsanlage bekannt, bei dem linear polarisiertes oder depolarisiertes Licht auf ein auswechselbares diffraktives optisches Element gerichtet werden kann, das zur Ausleuchtung einer nachfolgenden Pupillenebene verwendet wird.

ZUSAMMENFASSUNG DER ERFINDUNG

Vor diesem Hintergrund ist es Aufgabe der Erfindung, ein Beleuchtungssystem einer mikrolithographischen Projektionsbelichtungsanlage anzugeben, mit dem sich der Polarisationszustand des Projektionslichts gezielt in Abhängigkeit vom Beleuchtungswinkel einstellen läßt, unter dem Lichtstrahlen auf die Maske fallen.

Gelöst wird diese Aufgabe durch ein Beleuchtungssystem mit einer ersten optischen Anordnung zur Erzeugung eines Lichtbündels, bei dem das Licht wenigstens über einen Teil des Querschnitts des Lichtbündels hinweg unterschiedliche Polarisationszustände hat und räumlich wenigstens teilweise kohärent ist. Ferner ist eine zweite optische Anordnung vorgesehen, die zwischen der ersten optischen Anordnung und einer Pupillenebene angeordnet ist. Die zweite optische Anordnung teilt das Lichtbündel auf wenigsten zwei unterschiedliche Orte in der Pupillenebene auf und überlaqgrt die von der ersten optischen Anordnung erzeugten unterchiedlichen Polarisationszustände zu Pupillenpolarisationszuständen, die an den wenigstens zwei Orten unterschiedlich sind.

Die Erfindung beruht auf der Erkenntnis, daß man durch gezielte Überlagerung kohärenter Lichtanteile mit unterschiedlichen Polarisationszuständen in einer Pupillenebene eine Intensitätsverteilung erzielen kann, bei welcher der Polarisationszustand des Lichts in gewünschter Weise vom Ort abhängt, wodurch sich - bezogen auf die Maskenebene - die gewünschte Abhängigkeit des Polarisationszustands vom Beleuchtungswinkel einstellt.

Die erste optische Anordnung kann beispielsweise eine thermische Lichtquelle aufweisen, aus deren Licht mit Hilfe einer Lochblende kohärentes, aber unpolarisiertes Licht erzeugt wird. Mit Hilfe von Polarisationsfiltern und ggf. zusätzlichen Verzögerungsplättchen können daraus beispielsweise unterschiedliche lineare, zirkulare oder elliptische Polarisationszustände erzeugt werden, die dann mit Hilfe beugender oder brechender optischer Elemente in der Pupillenebene zu dem gewünschten Polarisationszustand überlagert werden.

Bei einem vorteilhaften Ausführungsbeispiel ändern sich die Polarisationszustände des von der ersten Anordnung erzeugten Lichtbündels wenigstens über den Teil des Querschnitts des Lichtbündels hinweg entlang wenigstens einer Richtung kontinuierlich und periodisch. Dadurch besteht die Möglichkeit, durch geeignete Überlagerung in weiten Grenzen beliebige Polarisationszustände in der Pupillenebene einzustellen.

Besonders einfach läßt sich die erste optische Anordnung realisieren, wenn die Lichtquelle linear polarisiertes und räumlich wenigstens teilweise kohärentes Projektionslicht erzeugt, wie dies etwa bei Lasern der Fall ist. Mit Hilfe eines doppelbrechenden Prismas läßt sich dann der Polarisationszustand eines hindurchtretenden Lichtbündels entlang einer Richtung periodisch verändern. Das Prisma muß lediglich die Eigenschaft haben, das sich seine Dicke nur entlang einer Richtung verändert. Diese Bedingung wird z.B. von einem keilförmigen Prisma erfüllt. Da sich in diesem Fall die Dicke kontinuierlich ändert, verändert sich auch der Polarisationszustand eines hindurchtretenden Lichtbündels entlang dieser Richtung kontinuierlich. Eine ähnliche Wirkung wird erzielt, wenn mehrere Abschnitte, innerhalb derer sich die Dicke kontinuierlich ändert, diskontinuierlich aneinander angrenzen. Ein Beispiel hierfür ist z.B. ein Prisma mit einem sägezahnähnlichen Profil.

Bei einem anderen Ausführungsbeispiel hat das Prisma kein kontinuierliches, sondern ein gestuftes Dickenprofil. Falls die Stufen in einer Richtung ansteigen, so erhält das Prisma insgesamt die Form einer Treppe. Ein Prisma mit einem gestuften Dickenprofil verändert den Polarisationszustand eines hindurchtretenden Lichtbündels entlang der Richtung, in der sich die Dicke des Prismas ändert, nicht kontinuierlich, sondern diskontinuierlich. Je mehr Stufen pro Längeneinheit vorgesehen sind, desto weniger wird der durch Überlagerung erhaltene Polarisationszustand von Dickentoleranzen abhängen.

Hat das Prisma eine optische Doppelbrechungsachse, die einen Winkel von 45° zu einer Polarisationsrichtung des linear polarisierten Projektionslichts einschließt, so lassen sich alle denkbaren Polarisationszustände erzeugen. Dies wiederum ist Voraussetzung dafür, daß man auch in der Pupillenebene alle denkbaren Polarisationszustände durch geeignete Überlagerung kohärenter unterschiedlich polarisierter Lichtanteile erreichen kann.

Bei einer vorteilhaften Ausgestaltung weist die zweite Anordnung ein diffraktives optisches Element auf, das lokal variierende Beugungseigenschaften hat. Die Verwendung diffraktiver optischer Elemente ist insofern günstig, weil sich damit praktisch beliebige Winkelverteilungen erzeugen lassen. Der von dem diffraktiven optischen Element erzeugten Winkelverteilung entspricht im Fernfeld eine Intensitätsverteilung in der Pupillenebene.

Weist das diffraktive optische Element mindestens zwei parallel zueinander angeordnete Streifen mit unterschiedlichen Beugungseigenschaften auf, so lassen sich, insbesondere im Zusammenwirken mit einem doppelbrechenden Prisma, zwei Orte oder Bereiche mit unterschiedlichen Polarisationszuständen in der Pupillenebene ausleuchten.

KURZE BESCHREIBUNG DER ZEICHNUNGEN

Weitere Merkmale und Vorteile der Erfindung ergeben sich aus der nachfolgenden Beschreibung von Ausführungsbeispielen anhand der Zeichnungen. Darin zeigen:

Figur 1 eine Projektionsbelichtungsanlage in stark schematisierter perspektivischer Darstellung;

Figur 2 ein erfindungsgemäßes Beleuchtungssystem in einem vereinfachten Meridionalschnitt;

Figur 3 ein diffraktives optisches Element mit streifenförmigen Beugungsbereichen in einer perspektivischen Darstellung;

Figur 4 einen vergrößerten Ausschnitt aus der Figur 2 in einem X-Z-Schnitt;

Figur 5 einen vergrößerten Ausschnitt aus der Figur 2 in einem Y-Z-Schnitt;

Figur 6 die sich in der Pupillenebene des in der Figur 2 gezeigten Beleuchtungssystems einstellende Intensitäts- und Polarisationsverteilung;

Figur 7 eine Anordnung eines doppelbrechenden Keils und des in der Figur 3 gezeigten diffraktiven optischen Elements in einem X-Z-Schnitt;

Figur 8 die sich in der Pupillenebene eines Beleuchtungssystems gemäß einem anderen Ausführungsbeispiels einstellende Intensitäts- und Polarisationsverteilung;

Figur 9 eine an die Figur 3 angelehnte Darstellung eines diffraktiven optischen Elements gemäß einem weiteren Ausführungsbeispiel;

Figur 10 die mit dem in der Figur 9 gezeigten diffraktiven optischen Element erhaltene Intensitäts-und Polarisationsverteilung in der Pupillenebene in einer an die Figuren 6 und 8 angelehnten Darstellung;

Figur 11 eine an die Figur 7 angelehnte Darstellung einer Anordnung eines treppenförmigen Prismas und des in der Figur 3 gezeigten diffraktiven optischen Elements in einem X-Z-Schnitt.

BESCHREIBUNG BEVORZUGTER AUSFÜHRUNGSBEISPIELE

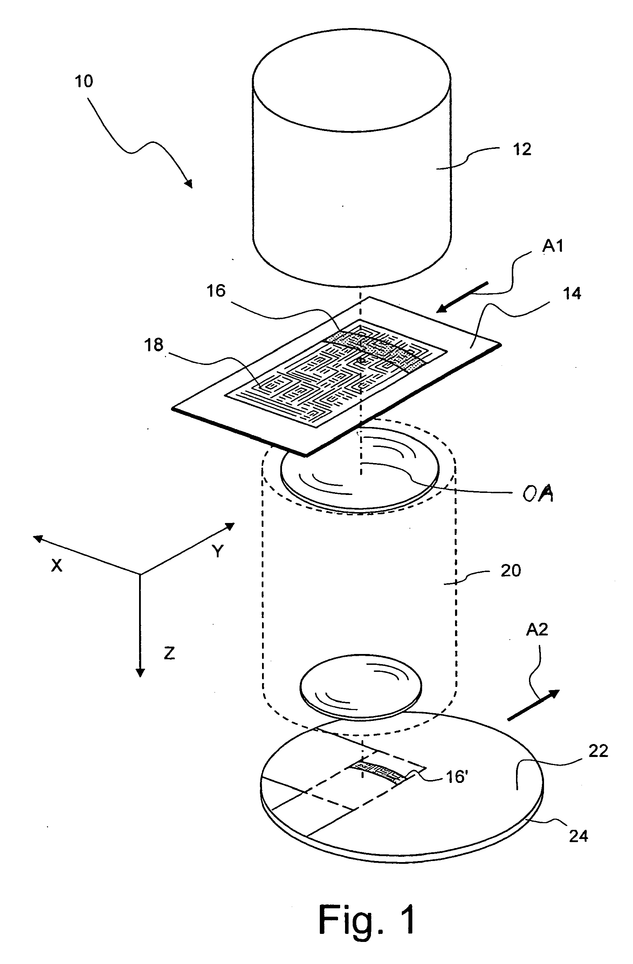

Die Figur 1 zeigt in einer stark schematisierten perspektivischen Darstellung eine Projektionsbelichtungsanlage 10, die für die lithographische Herstellung mikrostrukturierter Bauteile geeignet ist. Die Projektionsbelichtungsanlage 10 enthält ein Beleuchtungssystem 12 zur Erzeugung eines Projektionslichtbündels, das auf einer Maske 14 ein schmales, in dem dargestellten Ausführungsbeispiel ringsegmentförmiges Lichtfeld 16 ausleuchtet. Innerhalb des Lichtfeldes 16 liegende Strukturen 18 auf der Maske 14 werden mit Hilfe eines Projektionsobjektivs 20 auf eine lichtempfindliche Schicht 22 abgebildet. Die lichtempfindliche Schicht 22, bei der es sich z.B. um einen Photolack handeln kann, ist auf einem Wafer 24 oder einem anderen geeigneten Substrat aufgebracht und befindet sich in der Bildebene des Projektionsobjektivs 20. Da das Projektionsobjektiv 20 im allgemeinen einen Abbildungsmaßstab β < 1 hat, werden die innerhalb des Lichtfeldes 16 liegenden Strukturen 18 verkleinert als Bereich 16' abgebildet.

Bei der dargestellten Projektionsbelichtungsanlage 10 werden die Maske 14 und der Wafer 24 während der Projektion entlang einer mit Y bezeichneten Richtung verfahren. Das Verhältnis der Verfahrgeschwindigkeiten ist dabei gleich dem Abbildungsmaßstab β des Projektionsobjektivs 20. Falls das Projektionsobjektiv 20 eine Invertierung des Bildes erzeugt, verlaufen die Verfahrbewegungen der Maske 14 und des Wafers 22 gegenläufig, wie dies in der Figur 1 durch Pfeile A1 und A2 angedeutet ist. Auf diese Weise wird das Lichtfeld 16 in einer Scanbewegung über die Maske 14 geführt, so daß auch größere strukturierte Bereicht zusammenhängend auf die lichtempfindliche Schicht 22 projiziert werden können. Die Y-Richtung wird deswegen auch als Scanrichtung bezeichnet. Die Erfindung ist jedoch auch bei als Wafer-Stepper bezeichneten Projektionsbelichtungsanlagen einsetzbar, bei denen keine Verfahrbewegungen während der Projektion stattfinden.

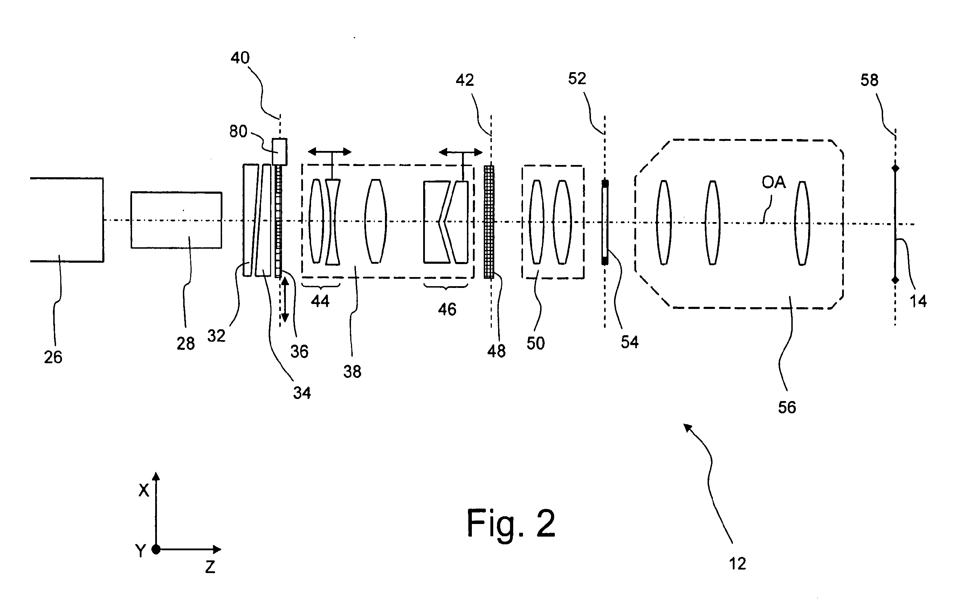

Die Figur 2 zeigt in einem vereinfachten und nicht maßstäblichen Meridionalschnitt Einzelheiten des Beleuchtungssystems 12. Das Beleuchtungssystem 12 enthält eine Lichtquelle 26, die zumindest teilweise räumlich kohärentes Projektionslicht erzeugt. Besonders geeignet als Lichtquelle 26 sind Laser, da das von Lasern emittierte Licht räumlich und zeitlich hochgradig kohärent ist. Bei dem hier beschriebenen Ausführungsbeispiel handelt es sich bei der Lichtquelle 26 um einen Excimer-Laser, mit dem sich Licht im (tiefen) ultravioletten Spektralbereich erzeugen läßt. Die Verwendung kurzwelligen Projektionslichts ist deswegen vorteilhaft, weil sich auf diese Weise eine hohe Auflösung bei der optischen Abbildung erzielen läßt. Gebräuchlich sind Excimer-Laser mit den Lasermedien KrF, ArF oder $F_2$, mit denen sich Licht mit den Wellenlängen 248 nm, 193 nm bzw. 157 nm erzeugen lassen.

Zumindest prinzipiell geeignet sind aber auch thermische Lichtquellen, wenn man aus dem davon erzeugten Licht, z.B. durch Verwendung kleiner Blendenöffnungen, (partiell) kohärente Lichtbündel erzeugt.

Das von dem als Lichtquelle 26 verwendeten Excimer-Laser erzeugte Licht ist stark gebündelt und divergiert nur schwach. Es wird deswegen zunächst in einem Strahlaufweiter 28 aufgeweitet. Bei dem Strahlaufweiter 28 kann es sich zum Beispiel um eine verstellbare Spiegelanordnung handeln, welche die Abmessungen des annähernd rechteckigen Lichtbündelquerschnitts vergrößert.

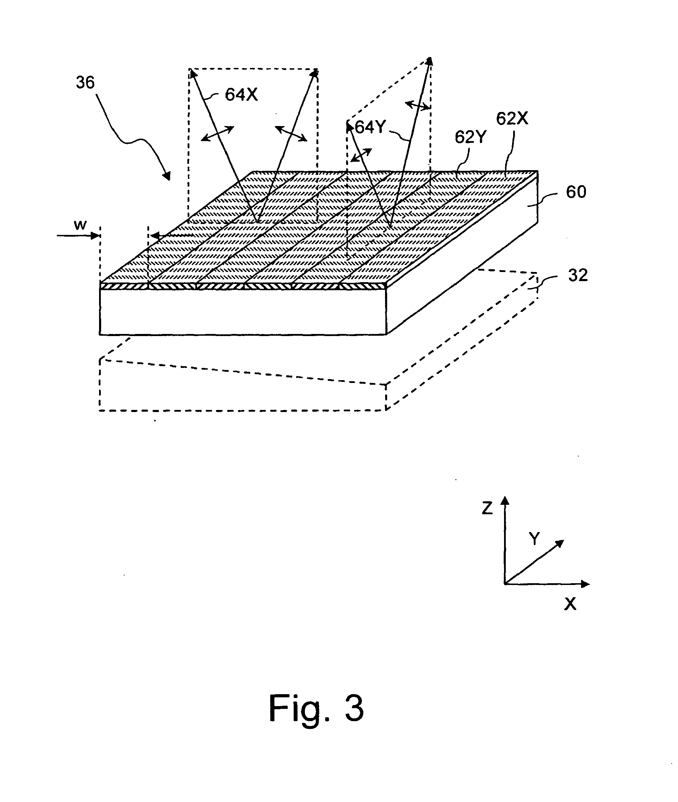

Das aufgeweitete Lichtbündel durchtritt anschließend ein optisch doppelbrechendes keilförmiges Prisma, das im folgenden kurz als Keil 32 bezeichnet wird, ein Kompensatorelement 34 und ein diffraktives optisches Element 36. Mit Hilfe dieser optischen Elemente, die ausführlich weiter unten mit Bezug auf die Figuren 3 bis 9 erläutert werden, lassen sich Beleuchtungswinkelverteilungen einstellen, bei denen der Polarisationszustand vom Beleuchtungswinkel abhängt.

An das diffraktive optische Element 36 schließt sich eine Zoom-Axikon-Baugruppe 38 an, die zwischen einer Feldebene 40, in der das diffraktive optische Element 36 angeordnet ist, und einer Pupillenebene 42 eine Fourier-Beziehung herstellt. Dadurch treffen sich alle unter dem gleichen Winkel von der Feldebene 40 ausgehenden Lichtstrahlen in der Pupillenebene 42 im gleichen Punkt, während alle von einem bestimmten Punkt in der Feldebene 40 ausgehenden Lichtstrahlen die Pupillenebene 42 unter dem gleichen Winkel durchsetzen.

Die Zoom-Axikon-Baugruppe 38 enthält ein mit 44 angedeutetes Zoom-Objektiv sowie eine Axicon-Gruppe 46, welche zwei Axicon-Elemente mit konischen und zueinander komplementären Flächen enthält. Mit Hilfe der Axicon-Gruppe 46 läßt sich die radiale Lichtverteilung verändern, um auf diese Weise eine ringförmige Ausleuchtung der Pupillenebene 42 zu erzielen. Durch Verstellung des Zoom-Objektivs 44 lassen sich die Durchmesser der in der Pupillenebene 42 ausgeleuchteten Bereiche verändern.

In oder in unmittelbarer Nähe der Pupillenebene 42 ist ein optischer Integrator 48 angeordnet, bei dem es sich zum Beispiel um eine Anordnung von Mikrolinsen-Arrays handeln kann. Jede Mikrolinse bildet eine sekundäre Lichtquelle, die ein divergentes Lichtbündel mit einem durch die Geometrie der Mikrolinse vorgegebenen Winkelspektrum erzeugt. Die von den sekundären Lichtquellen erzeugten Lichtbündel werden durch einen Kondensor 50 in einer Zwischenfeldebene 52 überlagert, wodurch diese sehr homogen ausgeleuchtet wird.

In der Zwischenfeldebene 52 ist bei dem dargestellten Ausführungsbeispiel eine Feldblende 54 angeordnet, die mehrere verstellbare Schneiden und/oder eine Vielzahl schmaler fingerartiger Blendenelemente umfassen kann, die einzeln in den Lichtweg einführbar sind. Die Zwischenfeldebene 52 wird mit Hilfe eines Feldblendenobjektivs 56 auf die Objektebene 58 des Projektionsobjektivs 20 abgebildet, in welcher die Maske 14 angeordnet ist.

Die Figur 3 zeigt das diffraktive optische Element 36 in einer perspektivischen Darstellung. Darunter ist der Keil 32 gestrichelt angedeutet, um die relative Anordnung zwischen dem diffraktiven optischen Element 36 und dem Keil 32 zu verdeutlichen. Das bei diesem Ausführungsbeispiel dazwischen angeordnete Kompensatorelement 34 ist der Übersichtlichkeit halber nicht dargestellt.

Das diffraktive optische Element 36 weist ein Substrat 60 auf, das zumindest auf einer Seite, hier auf der von dem Keil 32 abgewandten Seite, unterschiedlich strukturierte Bereiche trägt. Bei dem dargestellten Ausführungsbeispiel handelt es sich bei diesen Bereichen um eine periodische Anordnung von Streifen 62X, 62Y, die alle die gleiche Breite w haben. Jeder der Streifen 62X enthält Beugungsstrukturen, welche das Licht in X-Richtung beugen, wie dies in der Figur 3 für zwei mit 64X bezeichnete Beugungsordnungen angedeutet ist. Die Beugungswinkel in der Z-X-Ebene sollen dabei bezüglich einer Z-Y-Ebene symmetrisch sein.

Für die Streifen 62Y gilt entsprechendes für die Y-Richtung, d.h. sie beugen das Licht ausschließlich in der Y-Z-Ebene, was in der Figur 3 durch zwei Beugungsordnungen 64Y angedeutet ist.

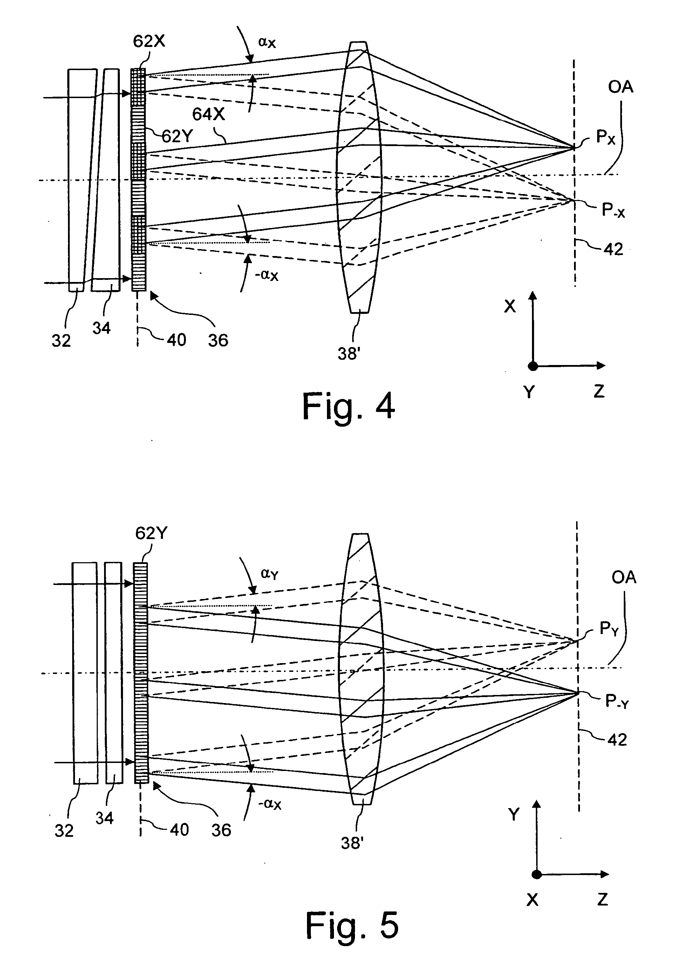

Die Figur 4 zeigt den Keil 32, das Kompensatorelement 34 und das diffraktive optische Element 36 in einem Schnitt parallel zur X-Z-Ebene. Die Zoom-Axikon-Baugruppe ist hier nur durch eine Linse 38' angedeutet, welche eine Fourier-Beziehung zwischen der Feldebene 40 und der Pupillenebene 42 herstellt. Infolge dieser Fourier-Beziehung treffen sich alle unter dem gleichen Winkel von dem diffraktiven optischen Element 36 ausgehenden parallelen Lichtstrahlen im gleichen Punkt. Beugen die Streifen 62X hindurchtretendes kollimiertes Licht ausschließlich in der X-Z-Ebene um Winkel $+\alpha_X$ und $-\alpha_X$, wie dies in der Figur 4 mit durchgezogenen bzw. gestrichelt dargestellten Linien angedeutet ist, so treffen sich die um den Winkel $\alpha_X$ gebeugten Strahlen alle in einem Punkt $P_X$ in der Pupillenebene 42 und die um den Winkel $-\alpha_X$ gebeugten Strahlen alle in einem Punkt $P_{-X}$. Auf diese Weise werden in der Pupillenebene 42 zwei Punkte ausgeleuchtet, die von einer optischen Achse OA des Beleuchtungssystems 10 gleich weit entfernt sind und sich einander diametral gegenüberliegen.

Entsprechendes gilt auch für die Streifen 62Y, welche das Licht ausschließlich in der Y-Z-Ebene beugen. Dies ist in der Figur 5 gezeigt, welche den Keil 32, das Kompensatorelement 34 und das diffraktive optische Element 36 in einem Schnitt parallel zur Y-Z-Ebene zeigt. Auch hier treffen sich die unter den Winkeln $\alpha_Y$ und $-\alpha_Y$ ausgehenden Lichtstrahlen in zwei Punkten $P_Y$ bzw. $P_{-Y}$ in der Pupillenebene 42.

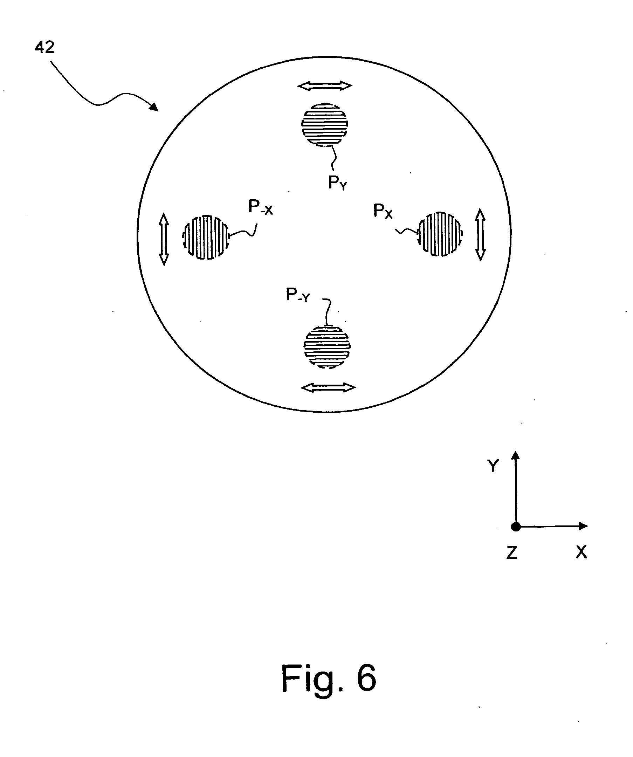

Die durch das diffraktive optische Element 36 erzeugte Lichtverteilung in der Pupillenebene 42 ist in der Figur 6 gezeigt. Hierbei wurde angenommen, daß die Beugung der Streifen 62X, 62Y so bestimmt wurde, daß sich anstelle von Punkten die mit $P_X$, $P_{-X}$, $P_Y$ und $P_{-Y}$ bezeichneten ausgedehnteren Pole ausbilden. Die Beugungsstrukturen sind dabei so klein, daß in den Streifen 62X, 62Y jeder Bereich, über dessen Ausdehnung hinweg die Dickenänderung des Keils 32 vernachlässigbar klein ist, ein Winkelspektrum erzeugt, das im Fernfeld, d.h. in der Pupillenebene 42, zu einem Paar von Polen $P_X$, $P_{-X}$ bzw. $P_Y$, $P_{-Y}$ führt.

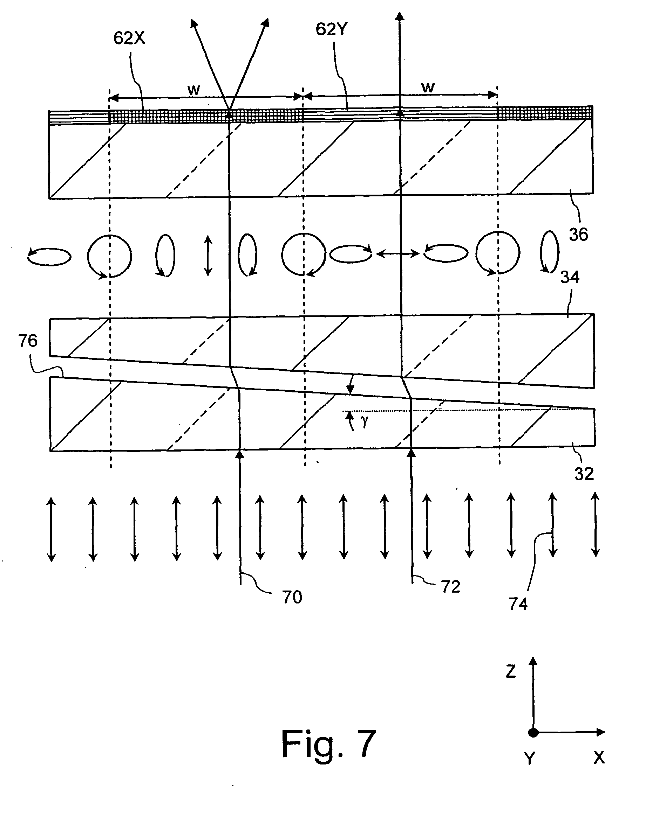

Die Figur 7 zeigt den Keil 32, das Kompensatorelement 34 und das diffraktive optische Element 36 vergrößert in einem Schnitt parallel zur X-Z-Ebene. Wie oben bereits erläutert, fällt auf den Keil 32 weitgehend kollimiertes, linear polarisiertes und hochgradig räumlich kohärentes Laserlicht. Zwei Strahlen des auf den Keil 32 auftreffenden Lichtbündels sind in der Figur 7 mit 70, 72 bezeichnet. Die lineare Polarisationsrichtung des Laserlichts innerhalb der X-Y-Ebene ist mit Doppelpfeilen 74 angedeutet, die Doppelpfeile 74 sind also um 90° "hochgeklappt" dargestellt.

Der Keil 32 besteht aus einem doppelbrechenden Material, zum Beispiel Magnesiumfluorid. Der Keil 32 hat einen Keilwinkel $\gamma$ und eine optische Doppelbrechungsachse, die einen Winkel von 45° zur Polarisationsrichtung 74 des auftreffenden Projektionslichts einschließt. Infolge der um den Keilwinkel $\gamma$ geneigt angeordneten oberen Keilfläche 76 werden die Lichtstrahlen 70, 72 beim Austritt aus dem Keil 32 gebrochen und dadurch in ihrer Richtung abgelenkt. Das Kompensatorelement 34 hat die Aufgabe, diese Ablenkung wieder rückgängig zu machen. Das Kompensatorelement 34 ist deswegen ebenfalls keilförmig, jedoch kann der Keilwinkel je nach Brechzahl des Kompensatorelements 34 von dem Keilwinkel $\gamma$ des Keils 34 verschieden sein.

Zwischen dem Kompensatorelement 34 und dem diffraktiven optischen Element 36 ist der Polarisationszustand in der X-Y-Ebene angedeutet, nachdem das Licht den doppelbrechenden Keil 32 durchtreten hat. Diese Darstellung ist ebenfalls (wie die Doppelpfeile 74) um 90° "hochgeklappt". Der Polarisationszustand eines Lichtstrahls nach dem Durchtritt des Keils 32 hängt davon ab, wie dick der Keil 32 am jeweiligen Durchtrittsort des Lichtstrahls ist. Da sich die Dicke des Keils 32 kontinuierlich in X-Richtung verändert, ändert sich auch der Polarisationszustand entlang dieser Richtung kontinuierlich. Es treten somit über die X-Richtung gesehen alle Polarisationszustände auf, wie sie in der Figur 7 unterhalb des diffraktiven optischen Elements 36 dargestellt sind. Dieser Darstellung ist auch entnehmbar, daß die Veränderung des Polarisationszustandes periodisch mit der Periode p ist. Die Breite w der Streifen 62X, 62Y ist dabei so gewählt, daß p = 2w gilt.

Im folgenden wird angenommen, daß innerhalb einer Streifenbreite w das Projektionslicht räumlich und zeitlich vollständig kohärent ist. Bei einem typischen Excimer-Laser liegt nach der Strahlaufweitung in dem Strahlaufweiter 28 die räumlich Kohärenz typischerweise in der Größenordnung von etwa 1 bis 2 mm. Die Annahme vollständiger Kohärenz ist somit bei Streifenbreiten w von weniger als 0,5 mm, besser noch von weniger als 0,25 mm, annähernd erfüllt.

Im folgenden wird ferner angenommen, daß zwei räumlich und zeitlich kohärente Photonen a und b einen der Streifen 62X durchtreten. Haben die beiden Photonen a, b eine im Vorzeichen entgegengesetzte Phase und gleiche Intensitäten nach dem Durchtritt durch den Keil 32, so überlagern sich die Photonen a, b in der Pupillenebene 42 zu linear polarisiertem Licht. Ausgenutzt wird dabei die Tatsache, daß durch die Zoom-Axikon-Baugruppe 38 eine Überlagerung der unter gleichem Winkel gebeugten Lichtstrahlen in einem Punkt stattfindet, wie dies oben mit Bezug auf die Figuren 4 und 5 erläutert wurde. Die Annahme gleicher Lichtintensitäten ist deswegen gerechtfertigt, weil innerhalb eines stetig verlaufenden Laserstrahlprofils an eng benachbarten Orten die Intensität praktisch konstant ist.

Die Überlagerung der hier betrachteten zwei Photonen a, b zu linear polarisiertem Licht läßt sich mathematisch durch die G1. (1) beschreiben:

$$E_{1a} + E_{1b} = \begin{pmatrix} E_{p1a}e^{i\mu} \\ E_{s1a} \end{pmatrix} + \begin{pmatrix} E_{p1b}e^{-i\mu} \\ E_{s1b} \end{pmatrix} = 2 \cdot \begin{pmatrix} \cos(\mu) \\ 1 \end{pmatrix} \qquad , \qquad \text{Gl. (1)}$$

wobei $E_{1a}$ und $E_{1b}$ die elektrischen Feldvektoren der beiden Photonen a und b sind und $\mu$ die Phase und damit den Polarisationszustand der Feldvektoren beschreibt. Mit den hier gleich 1 gesetzten Größen $E_{p1a}$, $E_{s1a}$, $E_{p1b}$ und $E_{s1b}$ sind die reellen Anteile der elektrischen Feldvektoren $E_{1a}$ und $E_{1b}$ parallel bzw. senkrecht zur optischen Doppelbrechungsachse des Keils 32 bezeichnet.

Die Addition der beiden Photonen a, b in der Pupillenebene 42 liefert somit gemäß Gl. (2) linear polarisiertes Licht, dessen Polarisationsrichtung jedoch um den Winkel

$$\arctan(1/\cos(\mu)) \qquad\qquad \text{Gl. (2)}$$

gegenüber dem Ausgangszustand verdreht ist.

Da sich aber in der Pupillenebene alle unter dem gleichen Winkel gebeugte Photonen in einem Punkt treffen, kommt es zu einer Überlagerung aller Photonen, die einen Streifen 62X der Breite w durchtreten. Wegen der Beziehung p = 2w liegen die Phasen $\mu$ der Photonen in einem Bereich zwischen - n/2 und + $\pi$/2. Mathematisch läßt sich die Überlagerung beschreiben als

$$E_p = \int_{-\pi/2}^{\pi/2} e^{i\mu/2} d\mu = 2 \cdot \sqrt{2} \quad \text{und} \quad E_s = \int_{-\pi/2}^{\pi/2} e^{-i\mu/2} d\mu = 2 \cdot \sqrt{2} \quad . \quad \text{Gl. (3)}$$

Die Überlagerung aller den Streifen 62X durchtretenden Photonen mit Polarisationszuständen zwischen links und rechts zirkular polarisiert ergibt also linear polarisiertes Licht, dessen Polarisationsrichtung hier parallel zur Polarisationsrichtung 74 ist, die das Licht vor dem Durchtritt durch den Keil 32 hatte.

Entsprechende Überlegungen gelten auch für die Streifen 62Y, nur daß dort durch die Überlagerung linear polarisiertes Licht entsteht, dessen Polarisationsrichtung um 90° gegenüber der ursprünglichen Polarisationsrichtung 74 verdreht ist. Die sich durch die Überlagerung ergebenden linearen Polarisationsrichtungen sind in der Figur 3 für die Beugungsordnungen 64X, 64Y durch Doppelpfeile angedeutet.

Infolge der vorstehend beschriebenen Überlagerung haben die beiden um 90° zueinander verdrehten Paare von Polen $P_X$, $P_{-X}$ einerseits und $P_Y$ und $P_{-Y}$ andererseits um 90° zueinander verdrehte Polarisationszustände, wie dies in der Figur 6 durch Doppelpfeile angedeutet ist. Insgesamt ergibt sich auf diese Weise eine tangentiale Polarisation, die für die Abbildung bestimmter Masken 14 besonders günstig ist.

Damit bei dem vorstehend beschriebenen Ausführungsbeispiel der Keil 32 die gewünschten Polarisationszustände erzeugt, muß folgender Zusammenhang zwischen der Periode p = 2w und dem Keilwinkel $\gamma$ gegeben sein:

$$\gamma = \arctan\left( \frac{\lambda}{p \cdot \Delta n} \right) \qquad , \qquad\qquad \text{Gl. (4)}$$

wobei $\lambda$ die Wellenlänge des Lichts und $\Delta n$ der Betrag der Differenz zwischen der Brechzahl $n_0$ des ordentlichen Strahls und der Brechzahl $n_a$ des außerordentlichen Strahls im doppelbrechenden Keil 32 bei der Wellenlänge $\lambda$ ist. Ferner ist die Anordnung der Streifen 62X, 62Y hier so gewählt, daß innerhalb einer Periode der Breite p vollständig ein Streifen 62X und ein Streifen 62Y Platz hat.

Selbstverständlich ist es möglich, anstelle des Kompensatorelements 34 einen weiteren doppelbrechenden Keil zu verwenden. Gegenüber dem in Figur 7 gezeigten Ausführungsbeispiel müssen die beiden Keile dann den gleichen Keilwinkel $\gamma$/2 haben. Alternativ hierzu kann auch die Breite w der Streifen 62X, 62Y halbiert werden, wenn beide doppelbrechenden Keile den Keilwinkel γ haben.

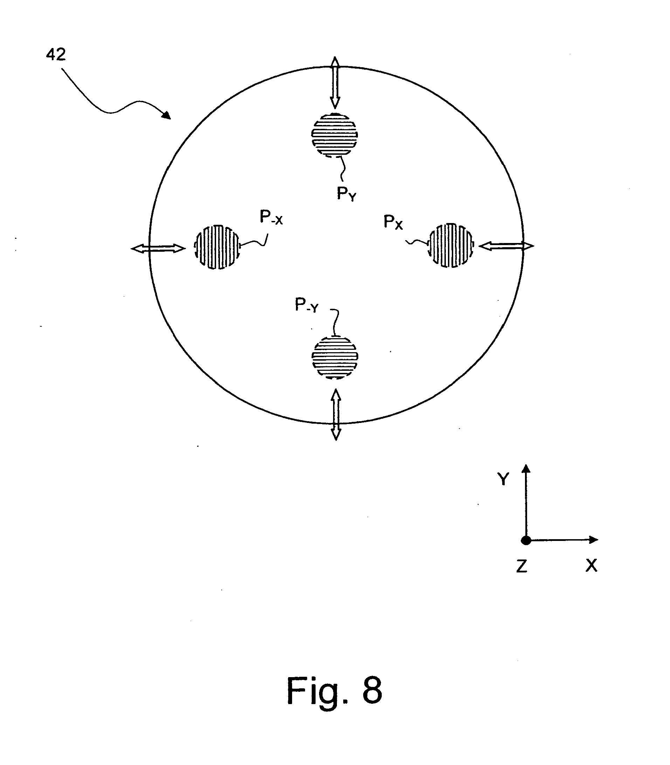

Sollen in den Polen $P_X$, $P_{-X}$, $P_Y$ und $P_{-Y}$ andere, zum Beispiel elliptische, Polarisationszustände eingestellt werden, so genügt es, das diffraktive optische Element 36 relativ zu dem Keil 32 entlang der X-Richtung zu verschieben. Das diffraktive optische Element bildet dann, zusammen mit einer geeigneten, in der Figur 2 mit 80 angedeuteten Verfahreinrichtung, einen einfach aufgebauten Polarisationsmanipulator zum Einstellen unterschiedlicher Polarisationszustände in der Pupillenebene 42. Wird dabei das diffraktive optische Element 36 um eine halbe Periode p/2 entlang der X-Richtung verschoben, so erhält man in der Pupillenebene 42 Pole $P_X$, $P_{-X}$, $P_Y$ und $P_{-Y}$ mit in radialer Richtung linear polarisiertem Licht, wie dies in der Figur 8 gezeigt ist.

Grundsätzlich ist es auch möglich, mehr als zwei unterschiedliche Arten unterschiedlich beugender Streifen vorzusehen, wobei auch die Anordnung dieser Streifen nicht unbedingt äquidistant sein muß. Dies ermöglicht die Einstellung von partiell polarisierten Polen in der Pupillenebene 42.

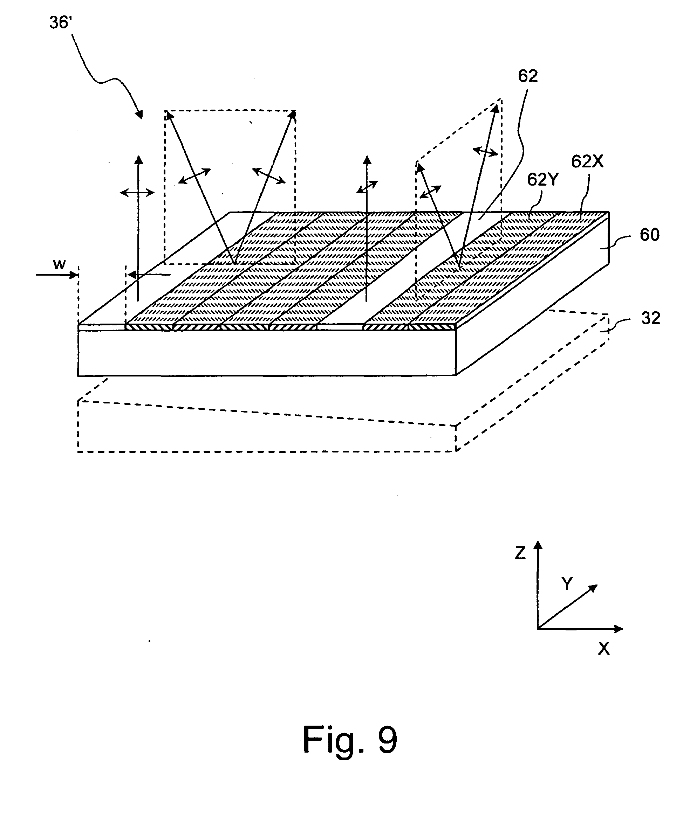

Die Figur 9 zeigt in einer an die Figur 3 angelehnten perspektivischen Darstellung ein weiteres Ausführungsbeispiel für ein diffraktives optisches Element, das hier insgesamt mit 36' bezeichnet ist. Im Unterschied zu dem in der Figur 3 gezeigtem Ausführungsbeispiel enthält das diffraktive optische Element 32 Streifen 62, die keine Beugungsstrukturen enthalten. Das die Streifen 62 durchtretende Licht bleibt deswegen parallel zur optischen Achse kollimiert.

Auch in diesem Ausführungsbeispiel haben alle Streifen 62, 62X und 62Y die gleiche Streifenbreite w = p/2. Da die nicht mit Beugungsstrukturen versehenen Streifen 62 jedoch bei dem dargestellten Ausführungsbeispiel um zweieinhalb (allgemein 2m+1/2) Perioden zueinander versetzt angeordnet sind, ist das aus benachbarten unstrukturierten Streifen 62 austretende Licht orthogonal zueinander polarisiert. Ist der Abstand zwischen den unstrukturierten Bereichen 62 ferner groß genug, daß keine nennenswerte Kohärenzbeziehung mehr zwischen den aus den benachbarten Streifen austretenden Photonen besteht, so kommt es zu einer inkohärenten Überlagerung orthogonaler Polarisationszustände in der Pupillenebene 42, was zu unpolarisiertem Licht führt.

Da in den Streifen 62 keine Beugung stattfindet, wird das parallel zur optischen Achse aus den Streifen 62 austretende Licht durch die Zoom-Axikon-Baugruppe 38 in einem auf der optischen Achse liegenden Punkt in der Pupillenebene 42 fokussiert.

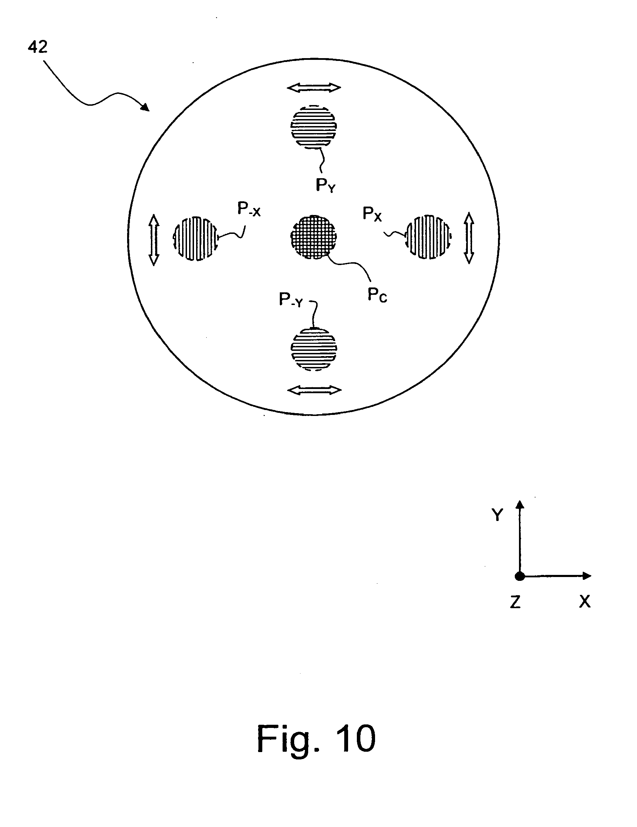

Soll in der Pupillenebene 42 ein zentraler ausgedehnterer Pol mit unpolarisiertem Licht ausgeleuchtet werden, so können in den Bereichen 62 schwach beugende Strukturen vorgesehen sein, die das Licht nur um relativ kleine Winkel ablenken. Die Figur 10 zeigt die sich dann ergebende Pupillenebene 42 in einer an die Figuren 6 und 8 angelehnte Darstellung. In der Mitte der Pupillenebene 42 befindet sich ein zusätzlicher Pol, der mit $P_c$ bezeichner ist und von unpolarisiertem Licht durchsetzt wird.

Eine alternative Möglichkeit zur Erzeugung eines unpolarisierten Pols besteht darin, Streifen auf dem diffraktiven optischen Element 36 vorzusehen, deren Breite deutlich größer ist als die räumlichen Kohärenzzellen des Laserlichts. Beträgt dann die Streifenbreite genau einem Vielfachen der Periode p, so entsteht unpolarisiertes Licht, wie man dies ähnlich auch in der eingangs bereits erwähnten US 6 535 273 beschrieben findet.

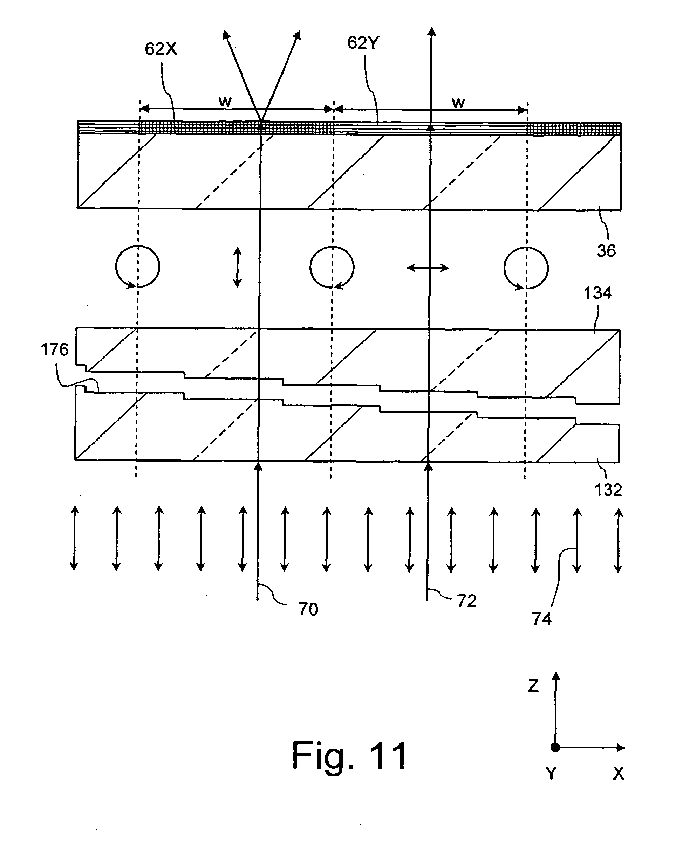

Die Figur 11 zeigt für ein anderes Ausführungsbeispiel in einer an die Figur 7 angelehnten Darstellung eine weitere Möglichkeit, wie man unterschiedliche Polarisationszustände erzeugen kann. Die in der Figur 11 gezeigte alternative Anordnung umfaßt ein doppelbrechendes treppenförmiges Prisma 132, ein Kompensatorelement 134 sowie das diffraktive optische Element 36 aus der Figur 3.

Das doppelbrechende Prisma 132 ist im wesentlichen genauso ausgelegt wird der Keil 32 bei dem in der Figur 7 gezeigten Ausführungsbeispiel. Insbesondere schließt auch hier die optische Doppelbrechungsachse einen Winkel von 45° zur Polarisationsrichtung 74 des auftreffenden Projektionslichts ein. Die geneigte Keilfläche 76, die bei dem in der Figur 7 gezeigten Ausführungsbeispiel eine kontinuierliche Dickenänderung bewirkt, ist bei dem doppelbrechenden Prisma 132 jedoch durch eine Stufenfläche 176 ersetzt, deren Stufen entlang der X-Richtung ansteigen. Das doppelbrechende Prisma 132 erhält somit insgesamt die Form einer Treppe.

Das Kompensatorelement 134 ist ebenfalls als treppenförmiges Prisma ausgebildet, ohne jedoch doppelbrechend zu sein. Benötigt wird das Kompensatorelement 134 nur für den Fall, daß nicht nur achsparallele Strahlen 70, 72 von unten auf das doppelbrechende Prisma 132 treffen, sondern auch Strahlen, die zur optischen Achse (geringfügig) geneigt sind. Das Kompensatorelement 134 gewährleistet dann, daß die Richtungsverteilung der durch das Prisma 132 und das Kompensatorelement 134 hindurchtretenden Strahlen unverändert bleibt. Die Wirkung des Kompensatorelements 134 entspricht insoweit prinzipiell der Wirkung des Kompensatorelements 34 der in der Figur 7 gezeigten Anordnung. Bei Abweichungen von der Brechzahl kann das Kompensatorelement 134 auch geneigt angeordnete brechende Flächen aufweisen. Bei hochgradig achsparallelem Licht kann das Kompensatorelement 134 vollständig entfallen.

Die Stufenfläche 176 und damit die Verteilung der Dicke (Abmessung entlang der Z-Richtung) des doppelbrechenden Prismas 132 entlang der X-Richtung ist so festgelegt, daß auftreffendes weitgehend kollimiertes, in Y-Richtung linear polarisiertes (siehe "hochgeklappte" Doppelpfeile 74) und hochgradig räumlich kohärentes Licht entweder in seinem Polarisationszustand nicht verrändert wird, die Polarisationsrichtung um 90° gedreht wird oder in rechts oder links zirkular polarisiertes Licht umgewandelt wird.

In dem dargestellten Ausführungsbeispiel ist die Verteilung der Dicke ferner so festgelegt, daß auf die Streifen 62X, 62Y jeweils Licht fällt, dessen Polarisationszustand in X-Richtung sich von zirkular polarisiert zu linear polarisiert zu umgekehrt zirkular polarisiert ändert. Diese Abfolge von Polarisationszuständen ist auch hier periodisch mit der Periode p, wobei ebenfalls p = 2w gilt.

Wie man anhand der Figur 11 unschwer erkennen kann, heben sich bei der Überlagerung von Licht, das einen der Streifen 62X, 62Y durchtritt, bei den zirkularen Polarisationszuständen die X-Komponenten oder.die Y-Komponenten jeweils gegenseitig auf, so daß nur die Y-Komponenten bzw. X-Komponenten verbleiben. An den Überlagerungspunkten in der Pupillenebene 42 ist deswegen auch bei diesem Ausführungsbeispiel das Licht entweder entlang der Y-Richtung oder entlang der X-Richtung linear polarisiert.

Selbstverständlich kann die Stufenfläche 176 auch anders ausgelegt sein. So können z.B. jedem Streifen 62X, 62Y auch zwei oder mehr als drei unterschiedliche Dicken zugeordnet sein. In Betracht kommt beispielsweise, zwei Dicken vorzusehen, die linear polarisiertes Licht in entgegengesetzt elliptisch polarisiertes Licht umwandeln. Damit der an den Überlagerungspunkten entstehende Polarisationszustand möglichst unempfindlich gegen Dickentoleranzen des doppelbrechenden Prismas 132 ist, wird es jedoch im allgemeinen günstiger sein, wenn jeder Zone 62X, 62Y eher mehr als weniger unterschiedliche Dicken zugeordnet sind. Je mehr unterschiedliche Polarisationszustände sich nämlich überlagern, desto weniger fällt es ins Gewicht, wenn eine einzelne Dicke nicht dem spezifizierten Wert entspricht. Ferner können sich Dickentoleranzen dann auch leichter gegenseitig ausgleichen.

**Patentansprüche**

1.  Beleuchtungssystem (12) einer mikrolithographischen Projektionsbelichtungsanlage (10), mit:

    a) einer ersten optischen Anordnung (26, 32; 132) zur Erzeugung eines Lichtbündels, bei dem das Licht wenigstens über einen Teil des Querschnitts des Lichtbündels hinweg

    - unterschiedliche Polarisationszustände hat und
    - räumlich wenigstens teilweise kohärent ist,

    b) einer Pupillenebene (42), und mit
    c) einer zweiten optischen Anordnung (36, 38),

    - die zwischen der ersten optischen Anordnung (26, 32; 132) und der Pupillenebene (42) angeordnet ist und
    - die das Lichtbündel auf wenigstens zwei unterschiedliche Orte ($P_X$, $P_{-X}$, $P_Y$, $P_{-Y}$) in der Pupillenebene (42) aufteilt und dabei die von der ersten optischen Anordnung erzeugten unterschiedlichen Polarisationszustände zu Pupillenpolarisationszuständen überlagert, die an den wenigstens zwei Orten ($P_X$, $P_{-X}$, $P_Y$, $P_{-Y}$) unterschiedlich sind.

2.  Beleuchtungssystem nach Anspruch 1, wobei sich die Polarisationszustände des von der ersten Anordnung (26, 32; 132) erzeugten Lichtbündels wenigstens über den Teil des Querschnitts des Lichtbündels hinweg entlang wenigstens einer Richtung (X) kontinuierlich und periodisch ändern.

3.  Beleuchtungssystem nach Anspruch 2, wobei die erste Anordnung aufweist:

    a) eine Lichtquelle (26) zur Erzeugung von linear polarisiertem und räumlich wenigstens teilweise kohärentem Projektionslicht und
    b) ein doppelbrechendes Prisma (32; 132), das den Polarisationszustand eines hindurchtretenden Lichtbündels entlang einer Richtung (X) periodisch verändert.

4.  Beleuchtungssystem nach Anspruch 3, wobei das Prisma (32) keilförmig ist und den Polarisationszustand eines hindurchtretenden Lichtbündels entlang der Richtung (X) kontinuierlich verändert.

5.  Beleuchtungssystem nach Anspruch 3, wobei das Prisma (132) ein gestuftes Dickenprofil hat und den Polarisationszustand eines hindurchtretenden Lichtbündels entlang der Richtung (X) diskontinuierlich verändert.

6.  Beleuchtungssystem nach einem der Ansprüche 3 bis 5, wobei das Prisma (32; 132) eine optische Doppelbrechungsachse hat, die einen Winkel von 45° zu einer Polarisationsrichtung des linear polarisierten Projektionslichts einschließt.

7. Beleuchtungssystem nach einem der vorhergehenden Ansprüche, wobei die zweite Anordnung (38) ein diffraktives optisches Element (36) aufweist, das lokal variierende Beugungseigenschaften hat.

8. Beleuchtungssystem nach Anspruch 7, wobei das diffraktive optische Element (36) mindestens zwei parallel zueinander angeordnete Streifen (62X, 62Y) mit unterschiedlichen Beugungseigenschaften aufweist.

9. Beleuchtungssystem nach Anspruch 8, wobei die Beugungseigenschaften der Streifen (62X, 62Y) periodisch wechseln.

10. Beleuchtungssystem nach Anspruche 4 und nach einem der Ansprüche 8 oder 9, wobei die Streifen (62X, 62Y) parallel zu einer Richtung (Y) angeordnet sind, die senkrecht zu einer optischen Achse (OA) des Beleuchtungssystems (12) und senkrecht zu einer Richtung verläuft, entlang der sich die Dicke des Prismas (32; 132) verändert.

11. Beleuchtungssystem nach einem der Ansprüche 8 bis 10, wobei erste Streifen (62X) das Licht in mehrere Richtungen in einer X-Z-Ebene und zweite Streifen (62Y) das Licht in mehrere Richtungen in einer Y-Z-Ebene beugen.

12. Beleuchtungssystem nach Anspruch 11, wobei die ersten Streifen (62X) im Fernfeld eine Dipol-Verteilung in X-Richtung und die zweiten Streifen (62Y) im Fernfeld eine Dipol-Verteilung in Y-Richtung erzeugen.

13. Beleuchtungssystem nach einem der Ansprüche 8 bis 12, wobei die Breite der Streifen (62X, 62Y) so gewählt ist, daß das einen einzelnen Streifen (62X, 62Y) durchtretende Licht bei Überlagerung an einem der wenigstens zwei Orte ($P_X$, $P_{-X}$, $P_Y$, $P_{-Y}$) eine Polarisationsvorzugsrichtung hat.

14. Beleuchtungssystem nach Anspruch 13, wobei die Breite (w) der Streifen (62X, 62Y) gleich einer halben Periode ist, mit der sich der Polarisationszustand des hindurchtretendes Lichtbündels periodisch verändert.

15. Beleuchtungssystem nach einem der Ansprüche 8 bis 14, wobei die Breite (w) der Streifen (62X, 62Y) so gewählt ist, daß das einen einzelnen Streifen (62X, 62Y) durchtretende Licht bei Überlagerung an einem der wenigstens zwei Orte ($P_X$, $P_{-X}$, $P_Y$, $P_{-Y}$) zumindest im wesentlichen linear polarisiert ist.

16. Beleuchtungssystem nach einem der Ansprüche 8 bis 15, wobei die Streifen (62X, 62Y) eine Breite (w) haben, die so klein ist, daß das einen Streifen (62X, 62Y) durchtretende Licht räumlich kohärent ist.

17. Beleuchtungssystem nach einem der vorhergehenden Ansprüche, mit einem Excimer-Laser als Lichtquelle (26).

18. Beleuchtungssystem nach Anspruch 16 und nach Anspruch 18, wobei die Streifen (62X, 62Y) eine Breite (w) haben, die kleiner ist als 0.5 mm.

19. Beleuchtungssystem nach Anspruch 18, wobei die Streifen (62X, 62Y) eine Breite (w) haben, die kleiner ist als 0.25 mm.

20. Verfahren zur Herstellung mikrostrukturierter Bauelemente, mit folgenden Schritten:

a) Bereitstellen einer mikrolithographischen Projektionsbelichtungsanlage (10) mit einem Beleuchtungssystem (12) nach einem der vorhergehenden Ansprüche;
b) Beleuchten einer Maske (14) mit dem Beleuchtungssystem (12),
c) Projizieren der beleuchteten Maske (14) auf eine lichtempfindliche Schicht (22).

## Claims

1. Illumination system (12) of a microlithographic projection exposure apparatus (10), comprising:

a) a first optical arrangement (26, 32; 132) for generating a light beam in which, at least over a part of the cross section of the light beam, the light

- has different polarisation states and
- is at least partially spatially coherent,

b) a pupil plane (42), and comprising

c) a second optical arrangement (36, 38),

- which is arranged between the first optical arrangement (26, 32; 132) and the pupil plane (42) and
- which splits the light beam onto at least two different positions ($P_X$, $P_{-X}$, $P_Y$, $P_{-Y}$) in the pupil plane (42) while superposing the different polarisation states generated by the first optical arrangement to form pupil polarisation states which are different at the at least two positions ($P_X$, $P_{-X}$, $P_Y$, $P_{-Y}$).

2. Illumination system according to Claim 1, wherein the polarisation states of the light beam which is generated by the first optical arrangement (26, 32; 132) change continuously and periodically along at least one direction (X) at least over the part of the cross section of the light beam.

3. Illumination system according to Claim 2, wherein the first arrangement comprises:

a) a light source (26) for generating linearly polarised and at least partially spatially coherent projection light and
b) a birefringent prism (32; 132) which periodically modifies the polarisation state of a light beam passing through along one direction (X).

4. Illumination system according to Claim 3, wherein the prism (32) is wedge-shaped and continuously modifies the polarisation state of a light beam passing through along the direction (X).

5. Illumination system according to Claim 3, wherein the prism (132) has a stepped thickness profile and discontinuously modifies the polarisation state of a light beam passing through along the direction (X).

6. Illumination system according to one of Claims 3 to 5, wherein the prism (32; 132) has an optical birefringence axis which makes an angle of 45° with a polarisation direction of the linearly polarised projection light.

7. Illumination system according to one of the preceding claims, wherein the second arrangement (38) comprises a diffractive optical element (36) which has locally varying diffraction properties.

8. Illumination system according to Claim 7, wherein the diffractive optical element (36) comprises at least two strips (62X, 62Y) that are arranged mutually parallel and have different diffraction properties.

9. Illumination system according to Claim 8, wherein the diffraction properties of the strips (62X, 62Y) change periodically.

10. Illumination system according to Claim 4 and according to one of Claims 8 or 9, wherein the strips (62X, 62Y) are arranged parallel to a direction (Y), which extends perpendicularly to an optical axis (OA) of the illumination system (12) and perpendicularly to a direction along which the thickness of the prism (32; 132) varies.

11. Illumination system according to one of Claims 8 to 10, wherein first strips (62X) diffract the light in a plurality of directions in an X-Z plane and second strips (62Y) diffract the light in a plurality of directions in a Y-Z plane.

12. Illumination system according to Claim 11, wherein the first strips (62X) generate a dipole distribution in the X direction in the far-field and the second strips (62Y) generate a dipole distribution in the Y direction in the far-field.

13. Illumination system according to one of Claims 8 to 12, wherein the width of the strips (62X, 62Y) is selected so that the light passing through an individual strip (62X, 62Y) has a preferential polarisation direction when superposed on one of the at least two positions ($P_X$, $P_{-X}$, $P_Y$, $P_{-Y}$).

14. Illumination system according to Claim 13, wherein the width (w) of the strips (62X, 62Y) is equal to a half of the period with which the polarisation state of the light beam passing through varies periodically.

15. Illumination system according to one of Claims 8 to 14, wherein the width (w) of the strips (62X, 62Y) is selected so that the light passing through an individual strip (62X, 62Y) is at least substantially polarised linearly when superposed on one of the at least two positions ($P_X$, $P_{-X}$, $P_Y$, $P_{-Y}$).

16. Illumination system according to one of Claims 8 to 15, wherein the strips (62X, 62Y) have a width (w) which is so small that the light passing through a strip (62X, 62Y) is spatially coherent.

17. Illumination system according to one of the preceding claims, comprising an excimer laser as the light source (26).

18. Illumination system according to Claim 16 and according to Claim 18, wherein the strips (62X, 62Y) have a width (w) which is less than 0.5 mm.

19. Illumination system according to Claim 18, wherein the strips (62X, 62Y) have a width (w) which is less than 0.25 mm.

20. Method for producing microstructured components, comprising the following steps:

a) providing a microlithographic projection exposure apparatus (10) comprising an illumination system (12) according to one of the preceding claims;
b) illuminating a mask (14) with the illumination system (12),
c) projecting the illuminated mask (14) onto a photosensitive layer (22).


**Revendications**

1. Système d'éclairage (12) d'un appareil d'exposition par projection microlithographique (10), comprenant :

a) un premier dispositif optique (26, 32 ; 132) pour générer un faisceau lumineux, dans lequel la lumière

- possède différents états de polarisation et
- est spatialement cohérente au moins partiellement
au moins sur une partie de la section transversale du faisceau lumineux,

b) un plan de pupille (42), et
c) un deuxième dispositif optique (36, 38),

- qui est disposé entre le premier dispositif optique (26, 32 ; 132) et le plan de pupille (42) et
- qui répartit le faisceau lumineux sur au moins deux emplacements différents ($P_x$, $P_{-x}$, $P_y$, $P_{-y}$) dans le plan de pupille (42) et interfère ce faisant avec les différents états de polarisation générés par le premier dispositif optique pour former des états de polarisation de pupille qui sont différents auxdits au moins deux emplacements ($P_x$, $P_{-x}$, $P_y$, $P_{-y}$).

2. Système d'éclairage selon la revendication 1, dans lequel les états de polarisation du faisceau lumineux généré par le premier dispositif (26, 32 ; 132) changent continuellement et périodiquement au moins sur une partie de la section transversale du faisceau lumineux suivant au moins une direction (X).

3. Système d'éclairage selon la revendication 2, dans lequel le premier dispositif présente :

a) une source de lumière (26) pour générer une lumière de projection polarisée linéairement et spatialement cohérente au moins partiellement et
b) un prisme biréfringent (32 ; 132) qui modifie périodiquement l'état de polarisation d'un faisceau lumineux qui le traverse suivant une direction (X).

4. Système d'éclairage selon la revendication 3, dans lequel le prisme (32) est en forme de coin et modifie continuellement l'état de polarisation d'un faisceau lumineux qui le traverse suivant la direction (X).

5. Système d'éclairage selon la revendication 3, dans lequel le prisme (132) a un profil d'épaisseur étagé et modifie discontinuellement l'état de polarisation d'un faisceau lumineux qui le traverse suivant la direction (X).

6. Système d'éclairage selon une des revendications 3 à 5, dans lequel le prisme (32 ; 132) a un axe optique de biréfringence qui fait un angle de 45° avec une direction de polarisation de la lumière de projection polarisée linéairement.

7. Système d'éclairage selon une des revendications précédentes, dans lequel le deuxième dispositif (38) présente un élément optique diffractif (36) qui possède des caractéristiques de diffraction variables localement.

8. Système d'éclairage selon la revendication 7, dans lequel l'élément optique diffractif (36) présente au moins deux bandes (62X, 62Y) disposées parallèlement l'une à l'autre qui ont des caractéristiques de diffraction différentes.

9. Système d'éclairage selon la revendication 8, dans lequel les caractéristiques de diffraction des bandes (62X, 62Y) alternent périodiquement.

10. Système d'éclairage selon la revendication 4 et selon une des revendications 8 ou 9, dans lequel les bandes (62X, 62Y) sont disposées parallèlement à une direction (Y) qui est perpendiculaire à un axe optique (OA) du système d'éclairage (12) et perpendiculaire à une direction suivant laquelle l'épaisseur du prisme (32 ; 132) varie.

11. Système d'éclairage selon une des revendications 8 à 10, dans lequel des premières bandes (62X) diffractent la lumière dans plusieurs directions dans un plan X-Z et des deuxièmes bandes (62Y) diffractent la lumière dans plusieurs directions dans un plan Y-Z.

12. Système d'éclairage selon la revendication 11, dans lequel les premières bandes (62X) génèrent en champ lointain une distribution dipolaire en direction X et les deuxièmes bandes (62Y) en champ lointain une distribution dipolaire en direction Y.

13. Système d'éclairage selon une des revendications 8 à 12, dans lequel la largeur des bandes (62X, 62Y) est choisie de façon que la lumière qui traverse une seule bande (62X, 62Y) ait une direction de polarisation préférentielle en cas de superposition à un desdits au moins deux emplacements ($P_x$, $P_{-x}$, $P_y$, $P_{-y}$).

14. Système d'éclairage selon la revendication 13, dans lequel la largeur (w) des bandes (62X, 62Y) est égale à la moitié de la période avec laquelle l'état de polarisation du faisceau lumineux qui les traverse change périodiquement.

15. Système d'éclairage selon une des revendications 8 à 14, dans lequel la largeur (w) des bandes (62X, 62Y) est choisie de façon que la lumière qui traverse une seule bande (62X, 62Y) soit polarisée au moins essentiellement linéairement en cas de superposition à un desdits au moins deux emplacements ($P_x$, $P_{-x}$, $P_y$, $P_{-y}$).

16. Système d'éclairage selon une des revendications 8 à 15, dans lequel les bandes (62X, 62Y) ont une largeur (w) qui est assez petite pour que la lumière qui traverse une bande (62X, 62Y) soit spatialement cohérente.

17. Système d'éclairage selon une des revendications précédentes, avec un laser excimère comme source de lumière (26).

18. Système d'éclairage selon la revendication 16 et selon la revendication 18, dans lequel les bandes (62X, 62Y) ont une largeur (w) inférieure à 0,5 mm.

19. Système d'éclairage selon la revendication 18, dans lequel les bandes (62X, 62Y) ont une largeur (w) inférieure à 0,25 mm.

20. Procédé de construction de composants microstructurés, présentant les étapes suivantes :

   a) mise à disposition d'un appareil d'exposition par projection microlithographique (10) équipé d'un système d'éclairage (12) selon une des revendications précédentes ;
   b) éclairage d'un masque (14) avec le système d'éclairage (12),
   c) projection du masque éclairé (14) sur une couche photosensible (22).

## Fig. 1

Fig. 2

Fig. 3

Fig. 4

Fig. 5

Fig. 6

Fig. 7

Fig. 8

Fig. 9

Fig. 10

Fig. 11

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6535273 B
- US 20040057036 A1
- WO 2005017620 A

- EP 1367446 A1
- EP 1610181 A2
- US 20060055834 A1